Europäisches Patentamt

European Patent Office

Office européen des brevets

(11) Publication number: **0 067 591**
**B1**

(12) **EUROPEAN PATENT SPECIFICATION**

(45) Date of publication of patent specification: **30.04.86**

(21) Application number: **82302756.0**

(22) Date of filing: **27.05.82**

(51) Int. Cl.⁴: **H 01 B 12/00**

(54) Al-stabilized superconductor, and method of producing the same.

(30) Priority: **28.05.81 JP 81759/81**
**28.05.81 JP 81760/81**

(43) Date of publication of application:
**22.12.82 Bulletin 82/51**

(45) Publication of the grant of the patent:
**30.04.86 Bulletin 86/18**

(84) Designated Contracting States:
**AT BE CH DE FR GB IT LI LU NL SE**

(56) References cited:
**DE-B-1 665 554**
**GB-A-2 052 838**
**US-A-3 767 842**
**US-A-4 078 299**

(73) Proprietor: **AGENCY OF INDUSTRIAL SCIENCE AND TECHNOLOGY**
**3-1, 1-chome, Kasumigaseki**
**Chiyoda-ku Tokyo (JP)**

(73) Proprietor: **SUMITOMO ELECTRIC INDUSTRIES LIMITED**
**No. 15, Kitahama 5-chome Higashi-ku**
**Osaka-shi Osaka 541 (JP)**

(72) Inventor: **Onishi, Toshitada Electrotechnical Laboratory**
**1-4, Umezone 1-chome Sakura-mura**
**Niiharu-gun Ibaraki-ken (JP)**
Inventor: **Tateishi, Hiroshi Electrotechnical Laboratory**
**1-4, Umezone 1-chome Sakura-mura**
**Niiharu-gun Ibaraki-ken (JP)**
Inventor: **Koyama, Kenichi Electrotechnical Laboratory**
**1-4, Umezono 1-chome Sakura-mura**
**Niiharu-gun Ibaraki-ken (JP)**
Inventor: **Saito, Shiegeo**
**c/o Osaka Works of Sumitomo Electric Ind. Ltd.**
**1-3, Shimaya 1-chome Konohana-ku Osaka (JP)**
Inventor: **Nagata, Masayuki**
**c/o Osaka Works of Sumitomo Electric Ind. Ltd.**
**1-3, Shimaya 1-chome Konohana-ku Osaka (JP)**

**0 067 591**

(74) Representative: **Warren, Francis Charles et al
Baron & Warren 18 South End Kensington
London W8 5BU (GB)**

**Description**

The invention relates to Al-stabilized superconducting wire, and particularly to wire for use in superconducting magnet used in charging magnetic field, such as pulse magnet and the like, and the method for producing the same.

Superconducting material presently for use in superconducting magnetic wire comprises alloys, such as Nb-Ti or Nb-Zr, and intermetallic compounds, such as $Nb_3Sn$ or $V_3Ga$.

US—A—3767842 discloses a superconducting cable comprising an assembly of elemental conductors formed of unitary segments embedded in a conductive metallic matrix such as copper. The assembly is encased in a jacket of metal or metal alloy having relative high electrical resistivity, such as stainless steel or cupronickel, then impregnated with a metallic alloy having a low melting point which adheres to the jacket.

Generally, these materials are used in combation with high purity Cu or high purity Al as a stabilizer.

With development and practical use of superconducting magnets in recent years, demand has increased for wire of smaller size and lighter weight, higher current density, higher stability, and lower Ac loss, particularly for use in pulse magnets.

As regards three of these features, namely smaller size and lighter weight, greater current density and higher stability, high purity Al is particularly effective as a stabilizer with its low density which is less than 1/3 that of high purity Cu, high electroconductivity at very low temperatures, high heat conductivity and display of saturation property in magnetoresistance effect.

It is difficult, however, to combine Al and superconducting material directly as in the case of Cu, since Al is easily covered by an oxidized film and its mechanical strength is very different from that of superconducting material.

Thus Al and superconducting material are generally integrated by the following method. High purity Cu and superconducting material are combined, and then Al is integrated with the composite. This method, however, involves considerable difficulty, since the higher the purity of Al, the lower its mechanical strength.

Conventionally, therefore, one of the following processes has been adopted when using Al as a stabilizer.

1. High purity copper and superconducting material are combined. The composite thus obtained is covered by intertwisted Al wire and then compressed by means of a roller, Turk's head rolls or the like. The Al wire is caused to adhere to the composite of Cu and superconducting material by making use of difference of the coefficient of thermal expansion at low temperatures between Al and Cu.

2. High purity copper and superconducting material are combined. Copper-coated Al wires are intertwisted around the composite and soldered thereto.

3. The copper-coated Al wires are intertwisted around a predetermined number of superconducting elementary wires, produced by combining high purity copper and superconducting material, and soldered thereto.

The term 'superconducting elementary wire' is used herein to denote a composite comprising Cu and superconducting material.

GB—A—2052838 discloses the formation of a wire bundle composed of a plurality of superconducting multifilament wires stranded with normally conducting stabilizing wires of copper or aluminium, which are of different diameters. All the wires are coated with a thin surface layer of solder and are soldered together in the region of the lines of contact.

The Al-stabilized superconducting wire produced by the above processes are satisfactory as regards small size and light weight, high current density and high stability. The Al-stabilized superconducting wire is not however free from difficulties in respect of mechanical strength and AC loss in view of the fact that Al is disposed around the superconducting elementary wire and that a combination of high purity copper and superconducting material, i.e., Cu-sleeved superconducting elementary wire, is used.

Thus, when the superconducting wire is used in charging magnetic field, loss, generally known as AC loss, is unavoidable.

The AC loss can be divided into loss due to the inner structure of the superconducting wire and loss attributable to mechanical strength against the electromagnetic force applied to the wire when the superconducting wire is wound in a magnet.

The former loss consists of three components: hysteresis loss arising in the superconductor (e.g., NbTi filament itself); coupling loss due to electromagnetic coupling arising between the superconductors (e.g., between NbTi filaments and between superconducting elementary wires); and eddy current loss caused in the normal conductive metal parts (e.g. Cu and Al used as stabilizers).

The former loss conceivably comprises mechanical heat generation and movement of wound wire caused by repetitive electromagnetic force in charging magnetic field.

In the case of the superconducting wire for use in charging magnetic field, the AC loss should be minimized. Thus it is necessary that each of the aforedescribed losses is reduced, for example, by the following processes.

a. Against the hysteresis loss, the superconductor is formed into fine multi-cores (in the form of filaments).

b. Against the coupling loss, the electromagnetic coupling between the filaments and between superconducting elementary wires is severed by interposing high resistance material therebetween.

c. Against the eddy current loss, the area of the normal conductive metal part (stabilizing material) is reduced. However, the stabilizing material should have a total area not less than predetermined dimensions. In this case, the stabilizing material is not disposed enbloc in the predetermined amount but is divided so that the eventual total area is equal to said amount. Thus the eddy current loss can be reduced. In fine, it is necessary that the stabilizing material is dispersed and disposed around the superconducting elementary wire.

d. Against the mechanical heat generation and wire movement, the superconducting wire should have the maximal mechanical strength.

The above-described conventional Al-stabilized superconducting wire has a disadvantageous structure in respect of mechanical strength and eddy current loss since Al is disposed around the superconducting elementary wire. Conventionally, the surface of the superconducting elementary wire was covered by Al which was more susceptible to mechanical deformation and plastic deformation compared with the superconducting elementary wire. Thus the conductivity was liable to be reduced at low temperatures by the deformation.

Furthermore, Al is directly subjected to electromagnetic force and the like thereby making it difficult to satisfactorily maintain the mechanical strength and conductivity at low temperatures.

The Al wire disposed around the superconducting elementary wire, not only in case of composed process but also in case of intertwisted wire, is in the state of electromagnetic contact with each other. Since Al as stabilizer is disposed continuously (as an integrated whole), it caused the eddy current loss to increase.

The structure is disadvantageous against coupling current between the superconducting elementary wires in response that the superconducting wire is Cu-sleeved superconducting wire having high purity copper as matrix.

Since the elementary wires are sleeved with Cu, they are electrically in contact with each other with interposition of low resistance metal, e.g., Cu, when the superconducting wires are physically in contact with each other and Cu-Al-Cu when Al wires are interposed between the superconducting elementary wires. Thus coupling current arises between the superconducting elementary wires to result in coupling loss.

In the aforedescribed method of integrating superconducting wire and high purity Al wire by intertwisting, the mechanical and electrical contact between the superconducting wires, between the superconducting wire and Al wire, and between the Al wires, is not sufficient when the Al wire and superconducting wire are simply intertwisted with each other, or simply soldered after intertwisting. Thus the compound wire lacks mechanical strength and stability. It involves a further disadvantage of reduced current density due to considerable clearances left between the elementary wires.

These difficulties can be obviated by a method in which superconducting wire and Al wire are intertwisted, reduced and then impregnated with solder by immersion.

When the wires are reduced prior to solder impregnation, adhesion between the elementary wires is improved. Thus the mechanical and electrical contact after solder impregnation is improved thereby enabling the compound wires to have greater mechanical strength, stability and current density.

This method, however, has the following disadvantage. When Al intertwisted with superconducting wire has high purity (above 99.99%), the mechanical strength thereof is reduced, whereby reduction process after intertwisting is rendered very difficult.

For example, in case of processing by means of a wire drawing die after intertwisting, high purity Al in the intertwisted wire is susceptible to breaking, and once breakage occurs, the high purity Al is accumulated at the inlet of the die thereby making it impossible to obtain smoothly intertwisted wire.

Processing after intertwisting and prior to solder impregnation is practicable if the mechanical strength is increased by reducing the Al purity. This method, however, has a disadvantage in that reduced Al purity results in deterioration conductivity at very low temperatures. Since stability is also reduced, the advantages of Al as stabilizer will be substantially same as Cu only excepting the merit of light weight.

The present invention consists in an intertwisted superconducting cable comprising a core wire, aluminium stabilizing wires and wires of a composite of copper and superconducting material, said wires being soldered and pressed together to contact them, characterised in that:

(a) the core wire comprises a non-magnetic metal or an alloy thereof preferably copper or a copper alloy, or is a composite wire of copper and superconducting material,

(b) the aluminium wires are of a purity above 99.99% and

(c) the interstices between the individual wires are filled by immersion of the core cable in solder.

According to a further aspect of the invention there is provided a method for producing an intertwisted superconducting cable comprising a core wire, aluminium stabilizing wires and wires of a composite of copper and superconducting material, wherein said wires are soldered and pressed together to contact them, characterised in that:

(a) the core wire comprises a non-magnetic metal or an alloy thereof preferably copper or a copper alloy, or is a composite wire of copper and superconducting material,

(b) the aluminium wires are of a purity above 99.99% and

(c) the intertwisted cable is immersed in and impregnated with solder, the whole then being pressed to improve adhesion between the wires.

In one embodiment of the invention the core of said intertwisted wire comprises electrically insulated non-magnetic metal. Impregnating the composite with solder imparts greater toughness. Preferably, the elementary wire is subsequently subjected to heat treatment for the recovery of residual resistivity ratio of Al.

According to the invention, as described hereinbefore, since the surface of superconducting elementary wire and that of high purity Al wire are bonded to each other by solder impregnation, the intertwisted wire can be subjected to reduction process without the risk of breakage of the high purity Al wire, the clearance between the elementary wires being reduced by the reduction process thereby enabling to increase the current density. With improvement of adhesion between the elementary wires, the superconducting material and high purity Al wire are integrated into a complete composite material thereby enabling the intertwisted wire to have high mechanical toughness and improved electrical contact for high stability. Thus the invention enables to produce Al-stabilized superconducting wire of light weight and high current density.

According to the invention, the surface reduction ratio of the intertwisted wire in the reduction process after solder impregnation is preferably below 40% for the following reasons.

If the reduction after solder impregnation is too heavy, the solder layer on the surface is ununiformly distorted, whereby the texture of the elementary wire (particularly high purity Al) is occasionally exposed to result in wire breakage. Moreover, in some structure of the intertwisted wire, irregular deformation of the superconducting wire causes a degradation of critical current.

According to the invention, the surface of superconducting elementary wire and that of high purity Al wire are preferably coated by a layer of Sn, Sn-Pb or Sn-Ag, according to the need, so as to facilitate solder impregnation and reduction process after intertwisting.

The surface of high purity Al in particular should be Cu-coated or covered by plated layer of Sn, Sn-Pb or Sn-Ag so that it can be impregnated with solder by immersion.

According to the invention, the high purity Al wire has a purity above 99.99% for the following reasons.

If the purity is less than 99.99% electroconductivity at very low temperatures is reduced and the merit of high purity Al as stabilizer is substantially reduced to the level of Cu. Moreover, the heat treatment temperature (softening temperature) for recovering the residual resistance due to processing distorsion received during the Al wire drawing process and the reduction process after solder impregnation will be above 200°C, and the impregnated solder, in some cases, will be melted at this temperature.

According to the invention, the superconducting material, for example NbTi or $Nb_3Sn$, is preferably in the form of fine multi-filaments for the reduction of hysteresis loss, and high purity Cu disposed around each of the filaments is capable of eliminating local instability. Cu alloy sleeved fine multi-superconducting wire is preferable for the outer sleeve of the superconducting elementary wire thereby helping to cut off the coupling current between the elementary wires.

The superconducting elementary wires and high purity Al wires after intertwisting, solder impregnation and pressing process may have a round, square or any other cross-sectional configuration.

The pressing process can for example be selected from die drawing, groove rolling, roller die and Turk's head rolls.

According to the invention, the high purity Al wire is preferably subjected to heat treatment for the recovery of residual resistivity ratio since the residual resistivity ratio is reduced due to processing distorsion during the wire drawing, solder impregnation and co-working process. Though the heat treatment conditions depend on the purity of Al wire, kind of solder and processing degree, the conditions can be selected below the melting temperature of solder if the Al having a purity above 99.99% is used.

According to the invention, the solder for impregnation is preferably Sn-Pb alloy solder or Sn-Ag alloy solder in particular, though selectable from among various other materials.

The Al-stabilized superconducting wire according to the invention has the characteristics as described hereinunder in reference to the accompanying drawings.

Fig. 1 is a sectional view of an embodiment of Al-stabilized superconducting wire according to the invention.

Fig. 2 is a sectional view of intertwisted wire embodying the method according to the invention.

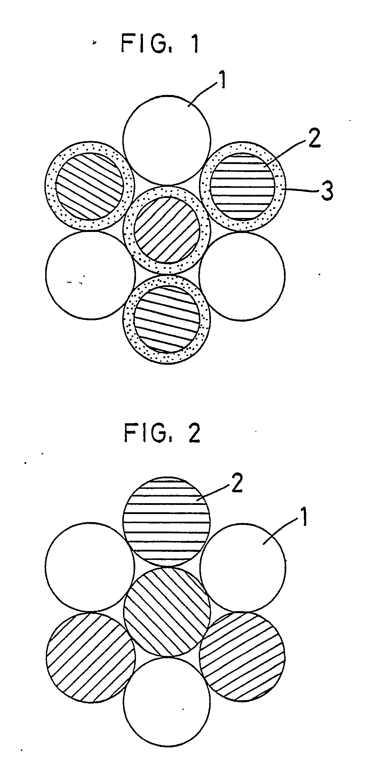

The Al-stabilized superconducting wire according to the invention will now be described in detail in respect to its mechanical toughness. Referring to Fig. 1, each of the high purity Al wires 1 is supported on three sides thereof by material of relatively high strength, such as superconducting elementary wire 2. Thus the Al-stabilized superconducting composite has greater mechanical strength against the external force, such as electromagnetic force, etc., compared with the case in which the whole periphery of the composite is covered by Al, thereby rendering the wire less susceptible to plastic deformation and free from a decline of electroconductivity at low temperatures due to distortion.

With a view to reducing eddy current loss, the high purity Al wire 1 is divided around the superconducting elementary wire 2, while a superconducting elementary wire having a high resistance Cu alloy shell 3 is infallibly disposed between the high purity Al wires 1, whereby the high purity Al wire 1 is not only free from electromagnetic coupling but also completely divided electromagnetically. Thus the eddy current loss is drastically reduced.

Coupling current does not easily arise between superconducting elementary wires since each of said wires has a shell 3 of high resistance Cu alloy. Thus the coupling loss between superconducting elementary wires is greatly reduced.

According to the invention, Cu alloy constituting the superconducting elementary wire comprises alloys of CuNi, Cu-Be, etc. which can be integrated with superconducting material, while having sufficient electrical resistance to reduce the coupling current.

Nonmagnetic metals and alloys thereof mainly Cu alloys for use in the core of the intertwisted wire according to the invention may be selected from among such metals as will not adversely affect the mechanical and electromagnetic properties of the intertwisted wire when used with the superconducting elementary wire.

More preferably, the metals have also sufficient strength to reinforce the intertwisted wire. It is necessary that the metals have sufficient electrical resistance to preclude electrical contact between Al wires and reduce eddy current loss.

When higher stability is taken into consideration, electrically insulated (e.g. Formal insulated) Cu is also recommendable.

Some of the superconducting wires intertwisted around the core may be replaced by electrically insulated non-magnetic metal or alloy thereof, preferably Cu or Cu alloy, having mechanical properties substantially same as or even higher than said superconducting elementary wire as well as electrical resistance capable of precluding electrical contact between Al wires.

The invention permits a still further alternative. If necessitated in connection with the design of the conductor relatively high resistance Cu alloy, such as Cu-Ni, may be provided around superconducting filaments which surrounded by high purity Cu capable of removing local instability, though the coupling loss is of a smaller order compared with that between superconducting elementary wires, so as to cut inter-filament coupling current. In fact, such Cu alloy sleeved mixed-matrix fine multi-filamentary wire may be used without impediment.

Though high purity Al is used as stabilizer in the invention for its light weight, high stability and the like, it can be replaced by high purity Cu in case where such properties are not very important.

The invention will now be described in more detail in reference to the following examples.

Example 1

Four Cu-Ni sleeved CuNi/Cu/NiTb mixed-matrix NbTi fine multi-filamentary superconducting elementary wires, each contains thirty-seven Nb-Ti filaments and 0.3 mmφ in outside diameter, 10 mm in twist pitch, and three high purity Al wires of 0.3 mmφ in diameter were intertwisted into the sectional construction as shown in Fig. 1, and the whole was impregnated with solder by immersion. The Al-stabilized superconducting wire thus obtained was excited from 0 to 6 Tesla in 2 seconds and then decreased again to 0 by semi-cycle pulse operation. AC loss was examined to find that eddy current loss of Al was 0.07 J/m, while coupling loss between superconducting elementary wires was 0.18 J/m, smaller by more than one order compared with the case of superconducting wire intertwisted by using copper-sleeved superconducting elementary wire and without dividing Al.

Example 2

Four superconducting elementary wires of 0.30 mmφ in outside diameter including thirty-seven Nb-Ti filaments, NbTi/Cu ratio is one to two, twist pitch 7 mm, and Pb-Sn eutectic solder-plated and three Sn plated high purity Al wires of a purity of 99.99%, 0.30 mmφ in outside diameter were intertwisted into the sectional construction as shown in Fig. 2, and the whole was impregnated with Pb-Sn eutectic solder by immersion.

The outside diameter was 0.92 mmφ.

The composite wire comprising solder impregnated superconducting elementary wires and high purity Al wires were drawn to 0.82 mmφ by an ordinary wire drawing machine. The area reduction ratio was 20%. Subsequently the wire was subjected to heat treatment at 150°C for 3 hours in order to recover residual resistivity ratio.

In this production process, no wire breakage has occurred despite the fact that high purity Al is mechanically very weak.

The sectional view of the Al-stabilized superconducting wire thus produced shows that each of the elementary wires is in complete contact with each other with interposition of a thin solder layer. A mechanical (tensile) test showed that the wire was completely integrated in respect of the mechanical properties.

The residual resistivity ratio of the high purity Al was about 1,000 after heat treatment, or more than four times as high as that of Cu generally used as stabilizer, three times as high in respspect of conductivity at low temperatures, and about ten times as high at 6 Tesla when magnetic resistance effect was taken into account. Thus the high purity Al has shown to have very high properties as stabilizer.

The Al-stabilized superconducting elementary wire thus obtained has been found to have very high stability, e.g., critical current being 110A at 6 Tesla, no nucleus-film boiling transition occurring on the surface of the superconducting conductor even when a current 2—3 times as high as the value of critical current was supplied and recovery current being greater than critical current.

The method according to the invention enables to obtain the following effects.

1. It enables to produce Al-stabilized superconducting wire mechanically integrated and toughened by the process of intertwisting, solder impregnation and reduction, the contact between each of the elementary wires being improved and integrated electrically.

2. It enables to produce with high yield Al-stabilized superconducting wire capable of being reduction without the risk of breaking high purity

Al wire, and having high packing factor, i.e., high stability permitting of higher current density.

3. Al-stabilized superconducting wire produced by this method has higher conductivity at low temperatures and better cooling property compared with Cu, since high purity Al wire above 99.99% is used. Thus it is not only effective as stabilizer but also highly economical since heat treatment for recovering the decline of conductivity at low temperature due to processing is practicable below the melting point of solder.

4. The use of Al enables to reduce the weight without deteriorating the properties of superconducting wire. In fact, the Al-stabilized superconducting wire according to the invention has been found to have high stability, low AC loss, light weight and high mechanical properties. The invention enables to produce said Al-stabilized superconducting wire industrially and economically.

**Claims**

1. An intertwisted superconducting cable comprising a core wire, aluminium stabilizing wires (1) and wires (2) of a composite of copper and superconducting material, said wires being soldered and pressed together to contact them, characterised in that:
(a) the core wire comprises a non-magnetic metal or an alloy thereof preferably copper or a copper alloy, or is a composite wire of copper and superconducting material,
(b) the aluminium wires (1) are of a purity above 99.99% and
(c) the interstices between the individual wires are filled by immersion of the core cable in solder.

2. A superconducting cable according to claim 1, characterised in that the core comprises an electrically insulated non-magnetic metal.

3. A superconducting cable according to claim 1 or claim 2, characterised in that the wires (2) of a composite of copper and superconducting material are fine multi-filamentary wires with a Cu or Cu alloy coating (3).

4. A method for producing an intertwisted superconducting cable comprising a core wire, aluminium stabilizing wires (1) and wires (2) of a composite of copper and superconducting material, wherein said wires are soldered and pressed together to contact them, characterised in that:
(a) the core wire comprises a non-magnetic metal or an alloy thereof preferably copper or a copper alloy, or is a composite wire of copper and superconducting material,
(b) the aluminium wires (1) are of a purity above 99.99% and
(c) the intertwisted cable is immersed in and impregnated with solder, the whole then being pressed to improve adhesion between the wires.

5. A method according to claim 4, characterised in that the impregnated and compressed cable is subjected to heat treatment for the recovery of residual resistance ratio of Al.

6. A method according to claim 4 or claim 5, characterised in that the surface of the high purity Al wire (1) is preliminarily covered by a Cu coating or an Sn, Sn-Pb or Sn-Ag plated layer.

7. A method according to any one of claims 4 to 6, characterised in that the surface of the superconducting wire (2) is preliminarily covered by Sn, Sn-Pb or Sn-Ag plated layer.

8. A method according to any one of claims 4 to 7, characterised in that the solder for impregnation is Sn-Pb alloy or Sn-Ag alloy.

9. A method according to any one of claims 4 to 8, characterised in that the area reduction ratio in the pressing stage is below 40%.

**Patentansprüche**

1. Ein verdralltes supraleitendes Kabel, bestehend aus einem Kerndraht, stabilisierenden Aluminiumdrähten (1) und Drähten (2) aus einer Zusammensetzung aus Kupfer und einem supraleitenden Material, wobei die Drähte durch Verlöten und Zusammenpression in Kontakt gebracht sind, dadurch gekennzeichnet,
(a) daß der Kerndraht aus einem nicht-magnetischen Metall oder einer Legierung hieraus, vorzugsweise aus Kupfer oder einer Kupferlegierung, besteht oder ein aus Kupfer und supraleitendem Material zusammengesetzter Draht ist,
(b) daß die Aluminiumdrähte (1) eine über 99,99% liegende Reinheit haben und
(c) daß die Hohlräume zwischen den einzelnen Drähten durch Tauchen des Kernkabels in Lot gefüllt sind.

2. Supraleitendes Kabel nach Anspruch 1, dadurch gekennzeichet, daß der Kern aus einem elektrisch isolierten nicht-magnetischen Metall besteht.

3. Supraleitendes Kabel nach Anspruch 1 oder 2, dadurch gekennzeichnet, daß die Drähte (2) aus einer Zusammensetzung aus Kupfer und supraleitendem Material feine multi-filamentartige Drähte mit einem Belag (3) aus Cu oder einer Cu-Legierung sind.

4. Verfahren zur Herstellung eines verdrallten supraleitenden Kabels, bestehend aus einem Kerndraht, stabilisierenden Aluminiumdrähten (1) und aus Drähten, die aus Kupfer und supraleitendem Material aufgebaut sind, wobei die Drähte durch Löten und Zusammenpression in Kontakt gebracht sind, dadurch gekennzeichnet, daß:
(a) der Kerndraht aus einem nicht-magnetischen Metall oder einer Legierung hieraus, vorzugsweise aus Kupfer oder einer Kupferlegierung, besteht oder ein aus Kupfer und supraleitendem Material aufgebauter Draht ist,
(b) die Aluminiumdrähte (1) eine über 99,99% liegende Reinheit haben und
(c) das verdrallte Kabel in Lot getaucht und hiermit imprägniert wird, wobei das ganze dann gepreßt wird, um die Adhäsion zwischen den Drähten zu verbessern.

5. Verfahren nach Anspruch 4, dadurch gekennzeichnet, daß das imprägnierte und gepreßte Kabel einer Wärmebehandlung zur Wiederherstellung des verbleibenden Widerstandsverhältnisses des Al unterworfen wird.

6. Verfahren nach Anspruch 4 oder 5, dadurch gekennzeichnet, daß die Oberfläche des hochreinen Al-Drahtes (1) vorbereitend mit einem Cu-Belag oder einer plattierten Lage aus Sn, Sn-Pb oder Sn-Ag überzogen wird.

7. Verfahren nach einem Ansprüche 4 bis 6, dadurch gekennzeichnet, daß die Oberfläche des supraleitenden Drahtes (2) vorbereitend mit einer plattierten Lage aus Sn, Sn-Pb oder Sn-Ag überzogen wird.

8. Verfahren nach einem der Ansprüche 4 bis 7, dadurch gekennzeichnet, daß das Lot für die Imprägnierung eine Sn-Pb- oder eine Sn-Ag-Legierung ist.

9. Verfahren nach einem der Ansprüche 4 bis 8, dadurch gekennzeichnet, daß das Flächenreduktionsverhältnis in der Preßstufe unterhalb 40% liegt.

**Revendications**

1. Câble supraconducteur torsadé comprenant un fil d'âme, des fils stabilisants d'aluminium (1) et des fils (2) d'un composite de cuivre et de matériau supraconducteur, ces fils étant soudés et pressés ensemble pour leur contact mutuel, caractérisé en ce que:

(a) le fil d'âme comprend un métal non magnétique ou un alliage de celui-ci, de préférence le cuivre ou un alliage de cuivre, ou bien est un fil composite de cuivre et de matéirau supraconducteur,

(b) les fils d'aluminium (1) sont d'une pureté supérieure à 99,99%, et

(c) les interstices entre les différents fils sont remplis par immersion du câble avec âme dans de la soudure.

2. Câble supraconducteur suivant la revendication 1, caractérisé en ce que l'âme comprend un métal non magnétique isolé électriquement.

3. Câble supraconducteur suivant la revendication 1 ou 2, caractérisé en ce que les fils (2) d'un composite de cuivre et de matériau supraconducteur sont de fins fils multifilamentaires munis d'un revêtement (3) de Cu ou d'alliage de Cu.

4. Procédé pour produire un câble supraconducteur torsadé comprenant un fil d'âme, des fils stabilisants d'aluminium et des fils (2) d'un composite de cuivre et de matériau supraconducteur, dans lequel ces fils sont soudés et pressés ensemble pour leur contact mutuel, caractérisé en ce que:

(a) le fil d'âme comprend un métal non magnétique ou un alliage de celui-ci, de préférence le cuivre ou un alliage de cuivre, ou bien est un fil composite de cuivre et de matériau supraconducteur,

(b) les fils d'aluminium (1) sont d'une pureté supérieure à 99,99%, et

(c) le câble torsadé est immergé dans et imprégné de soudure, l'ensemble étant ensuite pressé pour améliorer l'adhérence entre les fils.

5. Procédé suivant la revendication 4, caractérisé en ce que le câble imprégné et comprimé est soumis à un traitement thermique pour la restauration du rapport de résistance résiduelle de l'Al.

6. Procédé suivant la revendication 4 ou 5, caractérisé en ce que la surface du fil d'Al de haute pureté (1) est préalablement recouverte d'un revêtement de Cu ou d'une couche électrodéposée de Sn, Sn-Pb ou Sn-Ag.

7. Procédé suivant l'une quelconque des revendications 4 à 6, caractérisé en ce que la surface du fil supraconducteur (2) est préalablement recouverte d'une couche électrodéposée de Sn, Sn-Pb ou Sn-Ag.

8. Procédé suivant l'une quelconque des revendications 4 à 7, caractérisé en ce que la soudure pour l'imprégnation est un alliage Sn-Pb ou Sn-Ag.

9. Procédé suivant l'une quelconque des revendications 4 à 8, caractérisé en ce que le rapport de réduction de section au stade de pressage est inférieur à 40%.

## FIG. 1

## FIG. 2